# NEW EUROPEAN PATENT SPECIFICATION

(11) **EP 0 503 822 B2**
(45) Date of publication and mention of the opposition decision: **03.11.1999**
(45) Mention of the grant of the patent: 22.05.1996
(21) Application number: 92301822.0
(22) Date of filing: 03.03.1992
(51) Int. Cl.: C04B 41/85, C04B 41/89, C23C 14/16, C23C 14/18, C23C 16/00

(54) **A diamond- and/or diamond-like carbon-coated hard material**
Ein diamantbeschichteter und/oder mit diamantartigem Kohlenstoff beschichteter Hartstoff
Matériau dur revêtu de diamant et/ou de i-carbone

(30) Priority: 08.03.1991 JP 4360591
(43) Date of publication of application: 16.09.1992
(73) Proprietor: SUMITOMO ELECTRIC INDUSTRIES, LIMITED, Osaka 541 (JP)
(72) Inventor: Omori, Naoya, c/o Itami Works of Sumitomo, Itami-shi, Hyogo (JP); Nomura, Toshio, c/o Itami Works of Sumitomo, Itami-shi, Hyogo (JP)
(74) Representative: Allard, Susan Joyce

(56) References cited:
- US-A- 4 734 339
- DATABASE WPI Week 8336, Derwent Publications Ltd., London, GB; AN 83-755563 'Diamond coated superhard alloy tool' & JP-A-58 126 972 (SUMITOMO ELEC. IND. KK) 28 July 1983
- PATENT ABSTRACTS OF JAPAN & JP-A-61124573 ( TOSHIBA TUNGALOY CO LTD) 12-06-1986
- English language abstract of JP A 01246361
- Hartmetall für den Praktiker, 1988, p. 215
- Metall, 35. Jahrgang, Heft 12, Dec.1981, pp. 1253-1257
- Machine moderne, July 1972, pp. 13-17
- Vacuum, Vol. 41, n° 4-6, pp. 1317-13221 (1990)

## Description

This invention relates to a diamond-coated hard material having a diamond- or diamond-like carbon-coating layer with a high bonding strength to the substrate material.

Diamond has many excellent properties, for example, very high hardness, chemical stability, high heat conductivity, high sound wave propagation speed, etc. and has widely been used as a hard material utilizing these properties or as diamond or diamond-like carbon coated hard materials, illustrative of which are as follows:-
(i) single crystal diamond, sintered diamonds or diamond-coated cutting tools such as throwaway inserts, drills, microdrills, endmills, etc., which are capable of cutting Al, Cu, light metals or alloys thereof at a high temperature to produce well finished surfaces, because they hardly react with these metals or alloys.
(ii) various wear resistance tools such as bonding tools capable of working for a long time with high dimensional precision, because of high wear resistance;
(iii) various machine parts such as radiating plates;
(iv) various vibration plates such as speakers, and
(v) various electronic parts.

In the production of artificial diamond, there are various methods of forming diamond cutting layers from the gaseous phase, for example, the microwave plasma CVD method, RF-plasma CVD method, EA-CVD-method, induction field microwave plasma CVD method, RF hot plasma CVD method, DC plasma CVD method, DC plasma jet method, filament hot CVD method or combustion method. These methods are useful for the production of diamond-coated hard materials.

Since many of the diamond-coated hard materials are lacking in the bond strength of the diamond-coating to the substrate, the diamond-coating becomes stripped off, to shorten the life in many cases. The main reason therefor is that diamond is not capable of forming intermediate layers with all materials and it has low wettability with other materials.

In order to obtain a diamond-coated hard material having a high bonding strength, there have been proposed a method comprising selecting a substrate having the same heat expansion coefficient as diamond (Japanese Patent laid-Open Publication No. 291493/1986, proposing sintered compacts containing Si₃N₄, as a predominant component, and sintered compacts containing SiC as a predominant component), a method comprising subjecting the surface of a substrate to etching to remove metals having bad influences upon formation of the diamond coating layer on the substrate surface and thereby increasing the formation density of diamond nuclei on the substrate surface (Japanese Patent Laid-Open Publication No. 201475/1989, etching the surface of a cemented carbide with an acid solution to remove Co metal component and to suppress graphitization of the diamond nuclei; Japanese Patent Laid-Open Publication No. 124573/1986, subjecting the surface of a substrate to a scratching treatment with diamond grains or a diamond wheel and thereby improving the nuclei forming density on the surface of the substrate), etc. JP-A-58126972 relates to a coated superhard alloy tool comprising a superhard alloy substrate, an intermediate layer and an outer diamond layer.

As described above, diamond is chemically stable and does not form intermediate compounds with all materials. When a diamond-coated hard material having an excellent bonding strength is prepared, therefore, such a condition must be provided that the diamond coating layer and the substrate are strongly physically bonded.

We have found that when protrusions having a high bonding strength to a substrate are formed on the surface of the substrate by chemical or mechanical means and a diamond coating layer is formed thereon, thereby forming such a state that the protrusions intrude into the diamond coating layer, the bonding strength between the diamond cutting layer and the substrate is very high. This can be considered to be due to the fact that the contact area of the diamond coating layer with the substrate is increased and the protrusions have an anchoring action in the diamond coating layer, whereby the diamond coating layer is hard to strip from the substrate.

Accordingly, the present invention provides a coated hard material as defined in claim 1.

The present invention is further described hereinbelow with reference to the accompanying drawings, in which:
Figure 1 is a schematic view of an interface of an intermediate layer and diamond-coated layer in one embodiment of the present invention.
Figure 2 is a schematic view to illustrate the state shown in Figure 1 by linearly drawing it.
Figure 3 is a schematic view of an intermediate layer, the surface of which is roughened by a scratching treatment.
Figure 4 is a schematic view of an intermediate layer, the surface of which is roughened by coating hexagonal pillar or columnar crystals and/or needle-shaped crystals.
Figure 5 is a schematic view of an intermediate layer, the surface of which is roughened by etching.
Figure 6 is a schematic view of an intermediate layer, the surface of which is roughened by subjecting the outermost surface thereof to masking and then etching.
Figure 7 is a schematic view of an intermediate layer, the surface of which is roughened by a physical treatment, for example, using a laser beam.
Figure 8 is a schematic view of an example, in which the whole surface of a substrate is coated with an aggregate of fine grains.
Figure 9 is a schematic view of an example, in which the whole surface of a substrate is coated with coarse grains.
Figure 10 is a schematic view of an example, in which a substrate is partly coated with an aggregate of fine grains.
Figure 11 is a schematic view of an example, in which a substrate is partly coated with coarse grains.

As described above, diamond is chemically stable and does not form intermediate compounds with all materials. When a diamond-coated hard material having an excellent bonding strength is prepared, therefore, such a condition must be provided that the diamond coating layer and the substrate are strongly physically bonded.

We have found that the bonding strength between the diamond coating layer and the substrate is rendered very high, when at least one intermediate layer having a high bonding strength to the substrate as well as a high wettability with diamond is provided on the surface of the substrate, the outermost surface of the intermediate layer having a surface roughness characterized by the following features:
(1) microscopic roughness is present on the outermost surface of the intermediate layer and the surface roughness in a standard length is represented by an Rmax of 1.0 µm to 30 µm (i.e. state wherein protrusive parts are intruded in the diamond-coated layer) when the standard length is 50 µm, in the interface of the outermost surface of the intermediate layer and the diamond-coated layer.

A very high bonding strength can be obtained by selecting an intermediate layer capable of chemcially and/or mechanically bonding to a substrate. This can be considered to be due to the fact that the contact area of the diamond coating layer with the intermediate layer is increased by roughening the surface of the intermediate layer, thus resulting in a high physical bonding strength. Furthermore, when the substrate contains a material which is detrimental to the coating of diamond, the presence of intermediate layer serves to avoid the detrimental effect.

In the present invention, the surface roughness includes not only a macroscopically observed roughness formed by scratching with (1) a diamond wheel or (2) diamond grinding grains, which can be measured by a surface roughness meter, but also a surface roughness based on the presence of microscopic roughness in a micro section.

By the surface roughness in a micro section is meant a surface roughness in a standard length when the standard length is specified in the micro section e.g. 50 µm in the interlayer between the diamond-coated layer and the intermediate layer.

We have made various roughened states and consequently, have found that when the surface roughness on the interface of the intermediate layer is defined by Rmax of 1.0 µm to 30 µm in the standard length of 50 µm, a strong bonding strength is obtained. This outermost surface roughness is defined as the surface roughness (Rmax) of an intermediate layer after coating by lapping a cross-section of the intermediate layer coated with diamond, observing and photographing to review a boundary line of the diamond coating layer-intermediate layer interface. That is, the roughness is microscopically measured to seek the height between the peak and the bottom of a wave form. At the same time, a macroscopic undulation is sought by approximating it as linear and calculating.

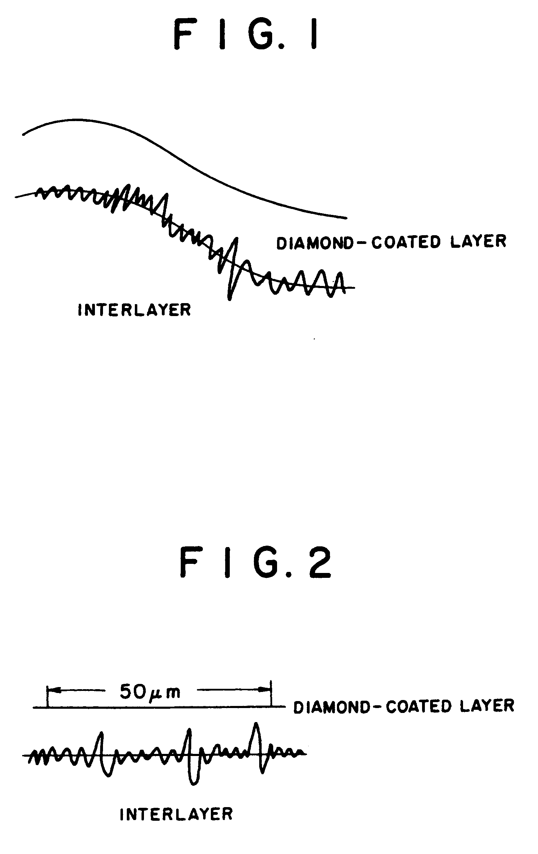

In Figure 1, the state of the interface between the diamond-coating layer or diamond-like carbon-coating layer and the intermediate layer according to the present invention is schematically shown. That is, a macroscopic undulation appears at the interface, but Rmax is calculated regarding this undulation as linear as shown in Figure 2.

As a useful method for roughening a surface to be coated with diamond, there are the following methods:
1. a method comprising scratching by a diamond wheel;
2. a method comprising coating the surface of an intermediate layer with a material which forms or contains columnar or hexagonal pillar crystal grains and/or needle crystal grains;
3. a method comprising etching the surface of an intermediate layer to give a roughened surface;
4. a method comprising masking the outermost surface of an intermediate layer, etching and then removing the mask;
5. a method comprising physically working, for example, for by applying a laser beam, brush, diamond wheel, etc.
6. a method comprising coating a part of a substrate with coarse grains and
7. a method comprising providing a coated part and non-coated part on the surface of a substrate.

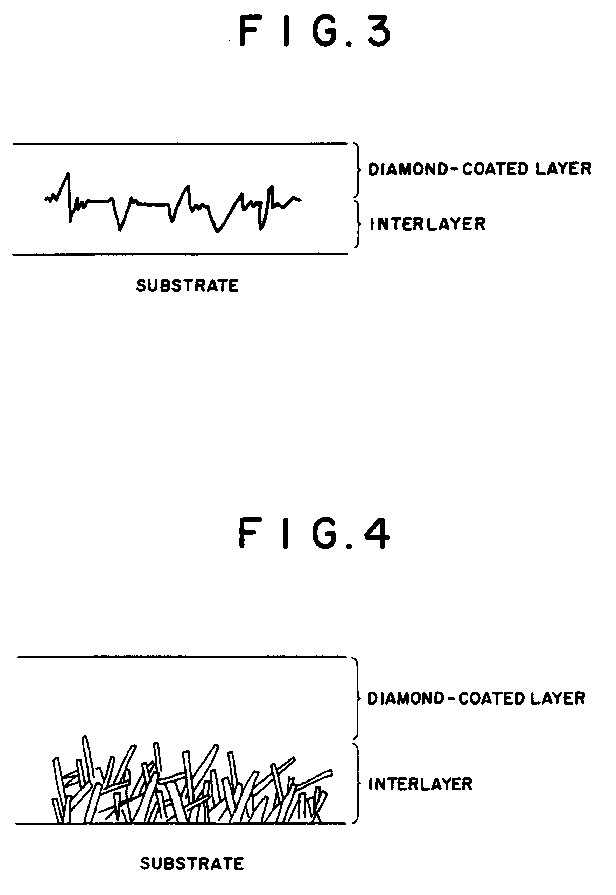

Depending on the type of substrate, a suitable method should be chosen therefrom. Method 1 consists in working the outermost surface of an intermediate layer by a resin-bonded or metal-bonded wheel using diamond or boron nitride grinding grains or an electrodeposited wheel, thus obtaining a roughened surface as shown in Figure 3.

Method 2 comprises depositing needle-shaped and/or hexagonal pillar crystals of silicon nitride, silicon carbide, aluminium oxide, etc. on the surface of an intermediate layer by the commonly used CVD method, plasma CVD method or RFCVD method, thus obtaining a roughened surface as shown in Figure 4.

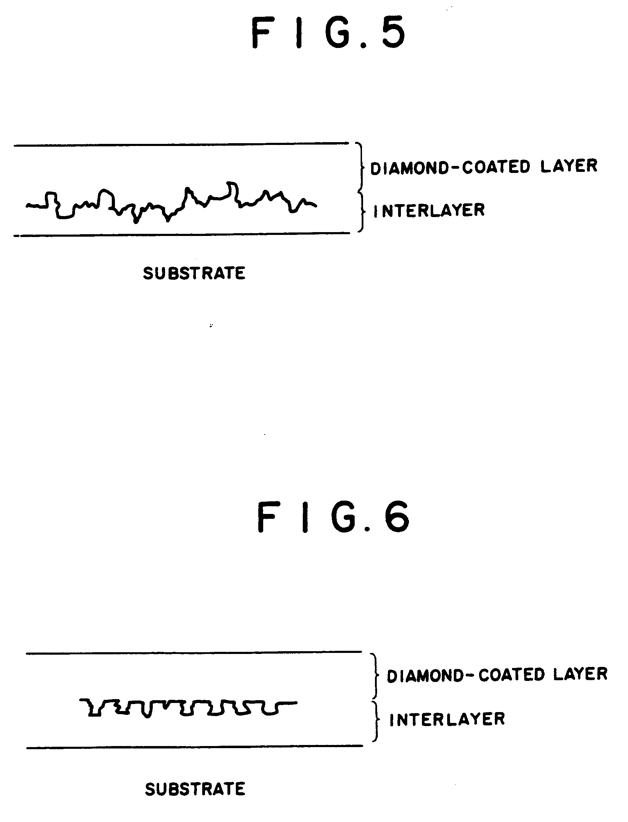

Method 3 comprises etching the outermost surface consisting of titanium carbide, nitride or carbonitride with an acid such as aqua regia to obtain a roughened surface as shown in Figure 5.

Method 4 consists in providing a patterned mask using a photomask, etc. and then removing the mask by etching, thus obtaining a roughened surface, for example, as shown in Figure 6, in which flat parts of the outermost surface of an intermediate layer correspond to the masked parts.

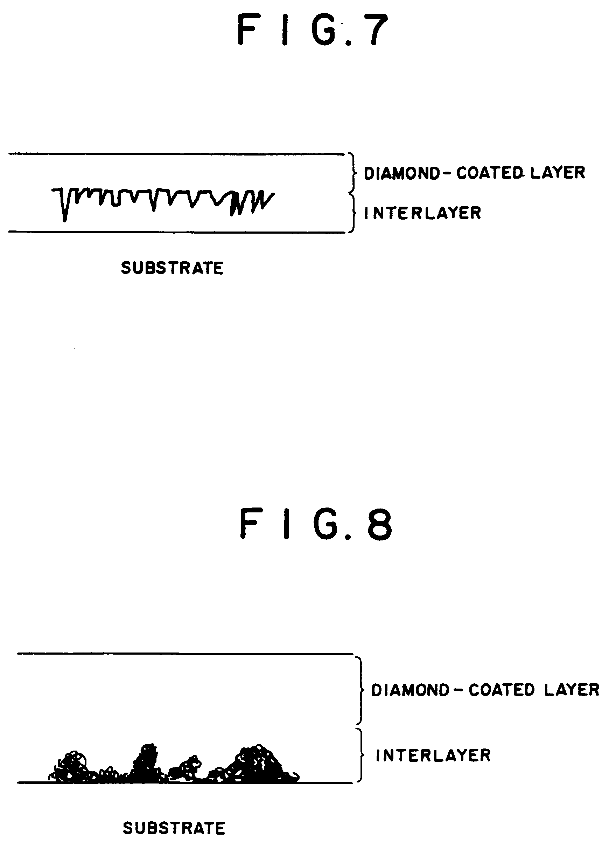

The method 5 comprises grooving the outermost surface of an intermediate layer using an argon laser or grooving the outermost surface of an intermediate layer using a diamond brush or various grinding wheels to obtain a roughened surface as shown in Figure 7.

Methods 6 and 7 comprise coating the surface of a substrate with coarse grains of at least one of tungsten, molybdenum, titanium and nitrides, carbides and carbonitrides of these metals, or controlling nucleation by the commonly used CVD method, plasma CVD method or RFCVD method and thus providing a coating layer which is not uniform in film thickness.

Figure 8 shows such a state that the outermost surface of an intermediate layer consists of fine grains and fully covers the whole surface of a substrate.

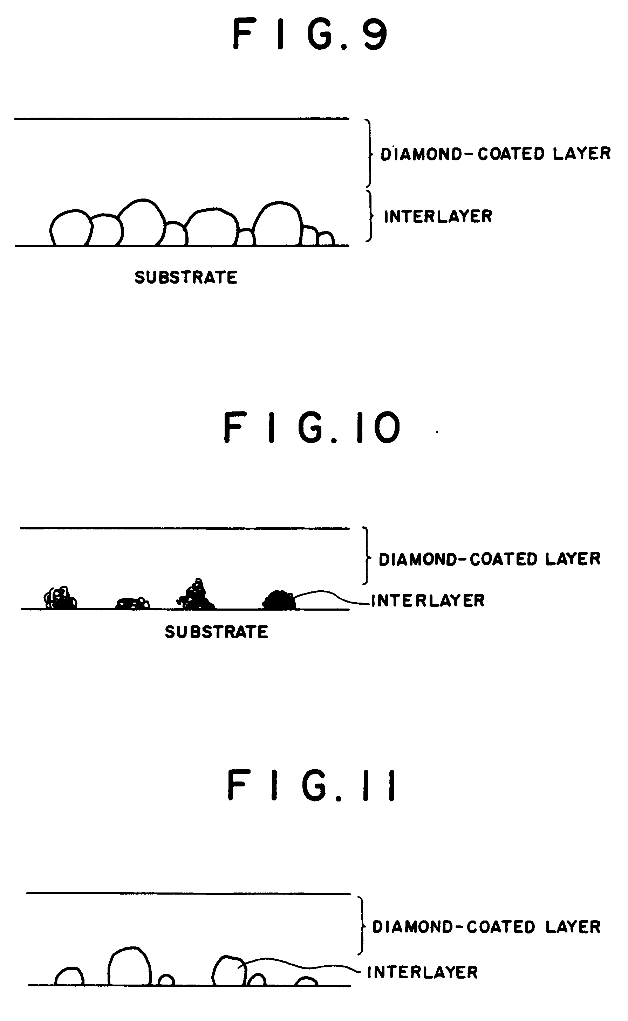

Figure 9 shows such a state that the outermost surface of an intermediate layer consists of coarse gains and fully covers the whole surface of a substrate.

Figure 10 shows such a state that a substrate is partly covered with an aggregate of fine grains.

Figure 11 shows such a state that a substrate is partly covered with coarse grains.

In any case, it is required that the outermost surface of an inetrmediate layer or interlayer has a surface roughness represented by an Rmax of 1.0 µm, to 30 µm in a standard length when the standard length is 50 µm in the interface between the diamond- and/or diamon-like carbon-coated layer and the intermediate layer. Preferably, protrusive parts are intruded in the diamond-coated layer by a length of at least 0.2 µm. When the surface roughness in the interface of the intermediate layer is represented by an Rmax of less than 1 µm, the bonding strength is not increased, while if more than 30µm, reversely the bonding strength is lowered. Moreover, if the maximum intrusive depth of the protrusive parts is less than 0.2 µm, the bonding strength is hardly changed.

It is found that when the intermediate layer or interlayer is wholly coated, the surface state becomes more uniform and nucleation more uniformly occurs, thus resulting in a more homogeneous film, as compared with when a substrate itself is roughened.

It is further found that when the intermediate layer or interlayer used in the present invention covers a surface, to be coated with diamond, in a proportion of at least 10 % based on the whole surface thereof, improvement of the bonding strength is achieved. That is, the benefits of the present invention can be obtained when 90 % of the area of the substrate is exposed, which corresponds to the case by the foregoing means ⑦ (Fig. 10 and fig. 11). In this case, the exposed area can have the similar surface roughness to the outermost surface of the interlayer.

In addition, it is found that when the outermost surface of the intermediate layer is of a material containing hexagonal pillar crystals with an aspect ratio of at least 1.5 or containing needle crystals, the bonding strength is further increased.

As a material for composing the intermediate layer, there can be used materials capable of readily causing nucleation, for example, silicon nitride, silicon nitride-containing materials, sialon, sialon-containing materials, silicon carbide, silicon carbide-containing materials, aluminum oxide, aluminum oxide-containing materials, at least one transition metal selected from the group consisting of Group 4, 5, 6 and 7 elements of Periodic Table, alloys of these metals, carbides, nitrides and/or carbonitrides thereof, such as titanium, titanium carbide or carbonitride, carbides or carbonitrides of titanium and at least one other metal and materials containing them, tungsten, tungsten carbide or carbonitride, carbides or carbonitrides of tungsten and at least one other metal and materials containing them. The outermost surface of the intermediate layer should preferably be a macroscopically coarse surface or microscopically roughness. The sialon includes α-sialon and β-sialon each corresponding to silicon nitride crystal whose Si and N atoms are partly respectively replaced by Al and O.

The intermediate layer can be a single layer or multi layer composed of at least two layers. In a case where the intermediate layer has a multilayer structure, as a layer in contact with a substrate, there is preferably selected a material having a high bonding strength to the substrate and as a layer in contact with a diamond-coated layer, i.e. a layer composing the outermost surface of the intermediate layer, there is preferably selected a material having a high bonding strength to diamond.

The intermediate layer, of either a single layer or a multilayer, has a mean layer thickness of 0.2 to 300 µm, since when the mean thickness is less than 0.2 µm with a coated area of less than 10 %, improvement of the bonding strength by the intermediate layer cannot be found, while when the thickness exceeds 300 µm, the bonding strength is reversely lowered.

The intermediate layer of the present invention can be formed by any of known methods, e.g. CVD methods, PVD methods, sputtering methods, etc.

As hard material cemented carbides, high speed steels, Fe, Mo, W and alloys thereof, Al₂O₃, silicon nitride, silicon carbide and other ceramics are used. Above all, when the roughness of silicon nitride, silicon carbide, titanium compounds such as titanium carbides, nitrides and carbonitrides and/or titanium compounds-containing materials, tungsten carbides and/or carbides of tungsten alloys and/or materials containing the compounds or materials are present, a high bonding strength can be obtained.

As to the mean thickness of the diamond- and diamon-like carbon-coated layer, if less than 0.1µm, no improvement of various properties by the coated layer, such as wear resistance, is found, while if more than 300 µm, further improvement of the properties cannot be given. Therefore, a mean layer thickness of 0.1 to 300 µm is used.

The foregoing illustration is conducted as to a case where diamond is coated, but the present invention can be applied with similar benefits to cases where diamond-like carbon is present in a diamond-coated layer, one or more of these layers are coated and the coated layer contains foreign atoms such as boron, nitrogen, etc. Even if an intermediate layer or diamond and/or diamond-like carbon is coated and then some heat treatment, e.g. a surface-smoothening treatment by contacting the surface of the diamond with a ferruginous metal at 1200 °C is carried out, improvement of the bonding strength according to the present invention can also be found.

The following examples are given in order to illustrate the present invention in detail without limiting the same.

Samples 7 and 8 are now outside the scope of the claims.

### Example 1

A throwaway insert comprising K 10 cemented carbides (specifically, WC-1.5 wt % NbC- 5 % Co) and ceramics based on silicon nitride (specifically, Si₃N₄-4 wt % Al₂O₃-4 wt % ZrO₂ -3 wt % Y₂O₃) as a substrate and having a shape of SPG 422 was prepared. On the surface of the insert were formed the following layers by the known gaseous phase synthesis method:
(1) AL₂O₃-TiC coating layer with a mean layer thickness of 3 µm (substrates: cemented carbides)
(2) AL₂O₃-TiC coating layer with a mean layer thickness of 3.5 µm (substrates: ceramics)
(3) TiN coating layer with a mean layer thickness of 2.5 µm (substrate: cemented carbides)
(4) TiN coating layer with a mean layer thickness of 4.0 µm (substrate: ceramics)
(5) SiC coating layer with a mean layer thickness of 3.5 µm (substrate: cemented carbides)
(6) Si₃N₄ coating layer with a mean layer thickness of 3.0 µm (substrate: cemented carbides)
(7) SiC coating layer with a mean layer thickness of 30µm (substrate: cemented carbides)
(8) SiC coating layer with a mean layer thickness of 100 µm (substrate: cemented carbides)
(9) Si₃N₄ coating layer with a mean layer thickness of 15 µm (substrate: cemented carbides)
(10) Si₃N₄ coating layer with a mean layer thickness of 80µm (substrate: cemented carbides)

On the outermost surface of the insert were deposited the following materials:
α-AL₂O₃ with a minor axis of 1.0 µm and a major axis of 10 µm in the cases of (1) and (2).
Needle-shaped TiN with a minor axis of 2.0 µm and a major axisof 5.0 µm in the cases of (3) and (4).
SiC whiskers with a minor axis of 1.5µm and a major axisof 9.0 µm in the case of (5).
Si₃N₄ hexagonal pillar crystals with a minor axis of 2.0 µm and a major axis of 6.0 µm in the case of (6).
SiC whiskers with a minor axis of 1.5µm and a major axis of 10 µm in the cases of (7) and (8).
Si₃N₄ hexagonal pillar crystals with a minor axis of 1.5 µm and a major axis of 5 µm in the cases of (9) and (10).

The each surface roughness was represented by an Rmax of 3 to 5 µm

In order to increase nucleation of diamond during coating of diamond, this insert and 2 g of diamond grains each having a grain diameter of 8 to 16 µm were added to ethyl alcohol and subjected to a scratching treatment by applying supersonic wave vibration for 15 minutes. The thus prepared insert was heated at 1000 °C and maintained in a mixed plasma of hydrogen-2 % methane at a total pressure of 80 Torr for 8 hours in a 2.45 GHz microwave plasma CVD apparatus, thus preparing diamond-coated cutting inserts (1) to (10) each having a layer thickness of 10 µm.

For comparison, comparative inserts were prepared by using a substrate having the same shape and composition as described above without coating the intermediate layer and providing a diamond coated layer on the insert after conducting the ultrasonic wave treatment under the same conditions as described above.
- Comparative Insert 1: substrate : cemented carbides
- Comparative Insert 2: substrate : ceramics

In this test, it was confirmed by the Raman spectrometry that the coated layer deposited on the surface of the substrate exhibited a peak at 1333 cm⁻¹ characteristic of diamond.

Using these cutting inserts, intermittent cutting tests were carried out under the following conditions.
- Workpiece to be cut: : Al-24 wt % Si alloy (block material)
- Cutting Speed: : 400 m/min
- Feed: : 0.1 mm/rev
- Cutting Depth: : 0.5 mm

When the flank wear width, the wear state of the edge and the deposition state of the workpiece, after 3 and 10 minutes, were observed, the cutting inserts of the present invention showed normal wearing represented by a flank wear width of:
(1) 0.035 mm, (2) 0.04 mm, (3) 0.038 mm, (4) 0.03 mm, (5) 0.04 mm (6) 0.045 mm, (7) 0.04 mm, (8) 0.035 mm, (9) 0.03 mm, (10) 0.028 mm
after 10 minutes from start of cutting and deposition of the workpiece was hardly observed.

In Comparative Insert 1, on the other hand, observation of the cutting edge after 3 minutes from start of cutting told that large peeling of the diamond-coated layer was found, the flank wear width amounted to 0.13 mm and the workpiece was subject to marked metal deposition, so that the cutting had to be stopped.

In Comparative Insert 2, similarly, fine peeling of the diamond-coated layer was observed, so that the cutting had to be stopped.

When the insert after the cutting test was cut, subjected to lapping and then the interface of the outermost intermediate layer and diamond coated layer was observed by an optical microscope, the insert of the present invention gave the results that hard crystals were intruded in the diamond-coated layer by a maximum depth of 2 to 4 µm as follows:
α-AL₂O₃ in the cases of the cutting inserts (1) and (2) of the present invention,
needle-shaped crystals in the cases of the inserts (3) and (4),
SiC whiskers in the cases of the inserts (5), (7) and (8),
Si₃N₄ hexagonal pillar crystals in the cases of the inserts (6), (9) and (10).
The microscopic surface roughness was represented by an Rmax of 3 to 4 µm in the standard length of 50 µm in the interface between the outermost surface of the intermediate layer and the diamond-coated layer.

### Example 2

A throwaway insert comprising K 10 cemented carbides (specifically, WC-5 % Co) and nitrogen-containing ceramics (specifically, 38 wt % TiC-12 wt % TiN-10 wt % TaN-10 wt % Mo₂C-15 wt % WC-5 wt % Ni-10 wt % Co) as a substrate and having a shape of SPG 422 was prepared. On the surface of the insert were formed the following layers, as an intermediate layer, by the known ion plating method:
(1) W having a grain diameter of 1.5 µm : coated area 30 % near cutting edge (substrate: cemented carbide).
(2) W having a grain diameter of 2.5 µm : coated area 60 % near cutting edge (substrate: cemented carbide).
(3) W having a grain diameter of 1.2 µm : coated area 100 % near cuttingedge (substrate: cemented carbide).
(4) W having a grain diameter of 1 µm : coated area 60 % near cutting edge (substrate: cermets).
(5) Ti having a grain diameter of 1 µm : coated area 60 % near cutting edge (substrate: cemented carbide).
(6) Ti having a grain diameter of 1.5 µm : coated area 60 % near cutting edge (substrate: cermets).
(7) Mo having a grain diameter of 2.0 µm : coated area 60 % near cutting edge (substrate: cemented carbide).
(8) Mo having a grain diameter of 2.5 µm : coated area 100 % near cutting edge (substrate: cemented carbide).

The surface roughness of these inserts was represented by an Rmax of 2 to 2.5 µm except (3) and that of the insert (3) was represented by an Rmax.

For comparison, Comparative inserts 3 (cemented carbide) and 4 (cermets) having no such intermediate layers were prepared.

All the inserts including the comparative inserts were subjected to a scratching treatment by ultrasonic wave vibration in an analogous manner to Example 1.

On the surface of the thus prepared insert was formed a diamond-coated layer with a thickness of 6 µm by the use of a known hot filament CVD method under the following conditions:
- Reaction Tube Vessel: : Quartz Tube of 200 mm in Diameter
- Filament Material: : Metallic W
- Filament Temperature: : 2400 °C
- Distance between Filament and Insert Surface: : 7.0 mm
- Total Pressure: : 100 Torr
- Atmospheric Gas: : H₂-1.5 % CH₄ Gas
- Time: : 7 hours

In this test, it was confirmed by the Raman spectrometry that the coated layer deposited on the surface of the substrate exhibited a peak at 1333 cm⁻¹ characteristic of diamond.

Using these cutting inserts, continuous cutting tests were carried out under the following conditions.
- Workpiece to be cut: : Al-12 wt % Si alloy (round rod)
- Cutting Speed: : 1000 m/min
- Feed: : 0.15 mm/rev
- Cutting Depth: : 1.5 mm

When the flank wear width, the wear state of the edge and the deposition state of the workpiece, after 5 and 30 minutes, were observed, the cutting inserts of the present invention except (3) showed normal wearing represented by a flank wear width of 0.03 mm to 0.04 mm after 10 minutes from start of cutting and deposition of the workpiece was hardly observed. In the case of the insert (3), the flank wear width was 0.08 mm and fine peeling was found in the cuting edge.

In Comparative inserts 3 and 4, on the other hand, observation of the cutting edge after 5 minutes from start of cutting told that a large peeling of the diamond coated layer was found, the flank wear width amounted to 0.23 mm or 0.20 mm and the workpiece was subject to marked metal deposition, so that the cutting had to be stopped.

When each of the inserts after the cutting test was cut, subjected to lapping and then the interface of the substrate and diamond coated layer has observed by an optical microscope, the insert of the present invention gave the results that W or Ti grains were intruded into the diamond-coated layer by at most 2. 0 µm and in the interface, the surface roughness was represented by an Rmax of 1.5 to 2.5 µm in the standard length of 50 µm. On the other hand, the insert (3) showed a microscopic Rmax of 0.4 µm.

### Example 3

Throwaway inserts each having a shape of SPG 422 were prepared using, as a substrate:
① K 10 cemented carbides (WC-0.4wt%TaC-0.2wt%NbC-5wt%Co),
② K 30 cemented carbides (WC-10wt%TiC-6wt%TaC-3wt%NbC-10wt%Co),
③ Nitrogen-containing cermet (38wt%TiC-12wt%TiN-10wt%TaN-10wt%Mo₂C-15wt%WC-5wt%Ni-10wt%Co)
④ High speed steel (DIN 1.3207)
These inserts were subjected to a surface-roughening treatment.

For comparison, Comprative Inserts (Sample Nos. 18-21, substrate materials corresponding to ① to ④) each having no interlayer on the substrate and Comparative Inserts (Sample Nos. 22 to 25) each having an interlayer but being not subjected to surface-roughening treatment were prepared. All the insert samples of the present invention including the comparative examples 18-21 were subjected to a scratching treatment by ultrasonic wave vibration in an analogous manner to Example 1 and provided with a diamond coated layer of 8 µm thickness on the surface thereof in an analogous manner to Example 2.

When these inserts were subjected to a cutting test under the same conditions as in Example 2, the inserts of Samples Nos. 4, 7, 8, 14 and 17 all showed normal wearing represented by a flank wear width of 0.03 to 0.04 after 30 minutes from start of cutting and no peeling of the diamond coated layer was found. In the other inserts of the present invention (except Sample Nos. 4, 7, 8, 14 and 17), a wearing corresponding to a flank wear width of about 0.06 to 0.08 was found with fine peeling of the coating layer but increase of the cutting resistance and decrease of the surface roughness of a workpiece did not take place. In Comparative Examples 18 to 25, on the other hand, a large peeling of the diamond coated layer was found after 3 minutes from start of cutting and the flank wear width exceeded 0.2 mm.

In Sample Nos. 7 and 8, the roughening of the outermost surface of the interlayer was considered insufficient so that the bonding strength of the diamond coated layer be lowered, while in Sample Nos. 4, 8, 14 and 17 using high speed steel as the substrate, fatigue of the edge took place due to the low strength of the substrate, thus resulting in peeling of the diamond coated layer.

In any case, as is evident from the examples of the present invention, the provision of the surface-roughened interlayer also serves to increase the bonding strength of the diamond coated layer to a great extent.

In addition, according to the features of the present invention, it is rendered possible to form a diamond coated layer having a sufficient bonding strength on a metallic substrate containing an element capable of dissolving carbon, such as iron, which has generally been considered difficult as to formation of the diamond coated layer. Specifically, in comparison with Samples using the substrates ① and ②, the substrate ② has a larger content of Co than the substrate ①, but the effects to be caused by this difference of the substrates are eliminated by the presence of the surface-roughened interlayer. In the case of using the substrate ④, it is also possible to form a diamond-coated layer with a sufficient bonding strength. In other words, according to the present invention, selection of materilas for the substrates to be coated with diamond can largely be widened.

It will clearly be understood from the above described illustaration and examples that the diamod- and/or diamond-like carbon-coated hard materials have better stripping resistance than those of the prior art. In Examples, the inserts using cemented carbides, silicon nitride-based ceramics and nitrogen-containing cermets as a substrate were applied to cutting tools, but it can well be expected therefrom that when using various hard materials such as silicon carbide- or Al₂O₃-based ceramics and other ceramics as a substrate, similar good results are a(so obtained. Furthermore, good results can be expected when the coated hard materials of the present invention are applied to wear resistance tools such as bonding tools, mechanical parts, endmills, drills, drills for printed plates, reamers, etc.

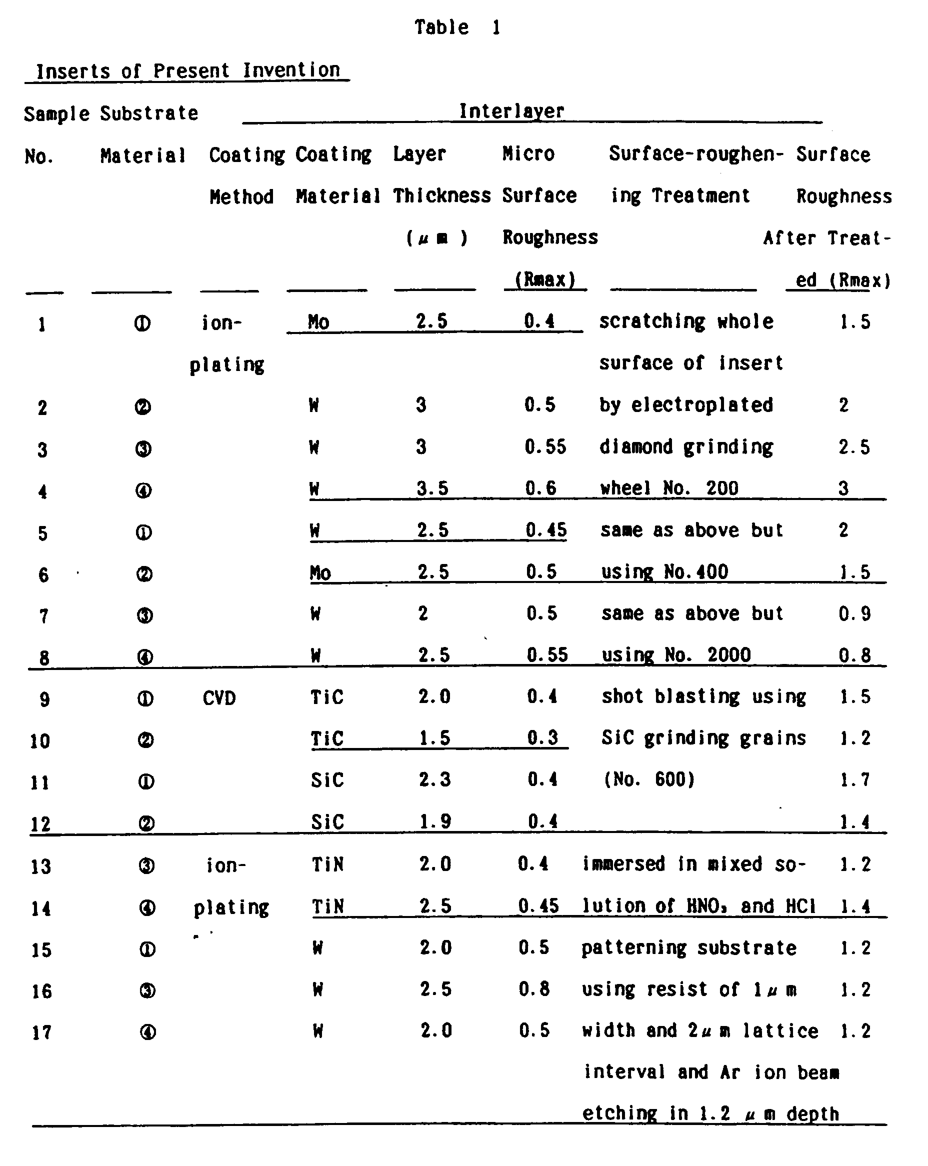

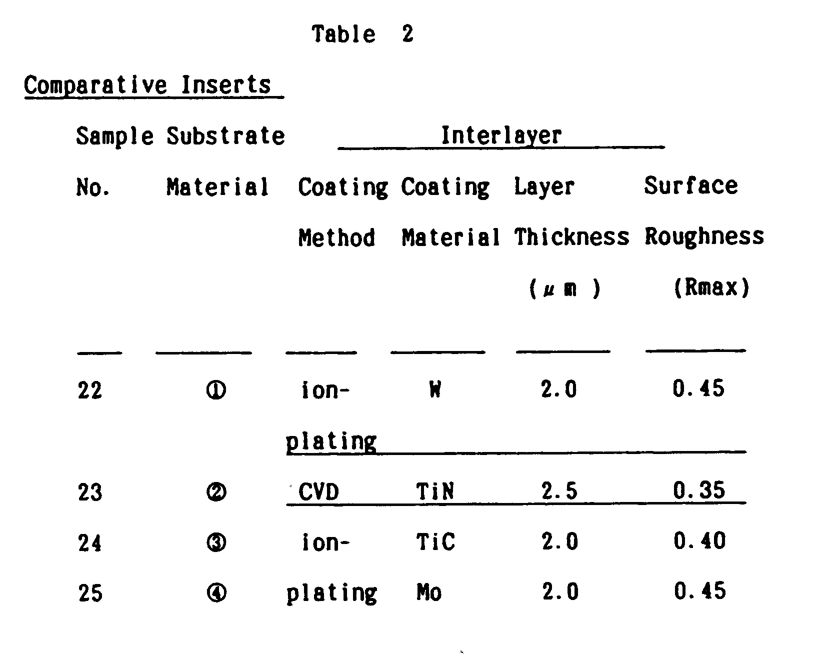

## Claims

1. A coated hard material comprising a diamond- and/or diamond-like carbon coating layer formed on the surface of a hard material, i.e. substrate, and the presence of at least one intermediate layer between the surface of the substrate and the diamond- and/or diamond-like carbon-coated layer, characterised in that microscopic roughness is present in the interface of the outermost surface of the intermediate layer and the diamond- and/or diamond-like carbon-coated layer, said surface roughness being represented in a standard length by an Rmax in the range of from 1.0 to 30 µm when the standard length is 50 µm, and wherein the hard material is (1) a cemented carbide, (2) Al₂O₃, silicon nitride, silicon carbide or other ceramic, (3) a mixed or composite material of the materials (1) and (2), a high speed steel, iron, molybdenum, tungsten or an alloy thereof, and wherein the mean thickness of the diamond- and/or diamond-like carbon coating layer is from 0.1 to 300 µm, and wherein the intermediate layer has a whole average layer thickness of from 0.2 to 300 µm.

2. A coated hard material as claimed in claim 1, wherein the intermediate layer has coated an area of at least 10% based on the whole surface to be coated with diamond and/or diamond-like carbon.

3. A coated hard material as claimed in claim 1 or claim 2, wherein the intermediate layer has an outermost surface consisting of at least one of silicon nitride, a silicon nitride-containing material, sialon or a sialon-containing material.

4. A coated hard material as claimed in claim 1 or claim 2, wherein the intermediate layer has an outermost surface consisting of silicon carbide or a silicon carbide-containing material.

5. A coated hard material as claimed in claim 1 or claim 2, wherein the intermediate layer has an outermost surface consisting of aluminium oxide or an aluminium oxide-containing material.

6. A coated hard material as claimed in claim 1 or claim 2, wherein the intermediate layer has an outermost surface consisting of (1) at least one transition metal of Group 4, 5, 6 and 7 of Periodic Table, alloys of these metals and (2) carbides, nitrides and/or carbonitrides thereof.

7. A coated hard material as claimed in claim 1 or claim 2, wherein the intermediate layer has an outermost surface consisting of (1) titanium, (2) titanium carbide or carbonitride, (3) carbides or carbonitrides of titanium and at least one other metal and/or (4) materials containing the materials (1) to (3).

8. A coated hard material as claimed in claim 1 or claim 2, wherein the intermediate layer has an outermost surface consisting of (1) tungsten, (2) tungsten carbide or carbonitride, (3) carbides or carbonitrides of tungsten and at least one other material and/or (4) materials containing the materials (1) to (3).

9. A coated hard material as claimed in claim 1 or claim 2, wherein a material in a hexagonal pillar form with an aspect ratio of at least 1.5 is present in the outermost surface of the intermediate layer.

10. A coated hard material as claimed in claim 1 or claim 2, wherein a material in a needle-shaped form is present in the outermost surface of the intermediate layer.

11. A coated hard material as claimed in any one of the preceding claims wherein the intermediate layer is a multilayer.

## Patentansprüche

1. Beschichteter Hartstoff, umfassend eine Deckschicht aus Diamant- und/oder diamantartigem Kohlenstoff, die auf der Oberfläche eines harten Materials, d.h. Substrats, ausgebildet ist, und die Anwesenheit von mindestens einer Zwischenschicht zwischen der Oberfläche des Substrats und der Deckschicht aus Diamant- und/oder diamantartigem Kohlenstoff, dadurch gekennzeichnet, dass in der Grenzfläche der äußersten Oberfläche der Zwischenschicht und der Deckschicht aus Diamant- und/oder diamantartigem Kohlenstoff mikroskopische Unebenheit vorhanden ist, wobei die Unebenheit der Oberfläche bei einer Standardlänge durch einen Rmax im Bereich von 1,0 bis 30 µm dargestellt ist, wenn die Standardlänge 50 µm beträgt, das harte Material (1) Sintercarbid, (2) Al₂O₃, Siliziumnitrid, Siliziumcarbid oder ein anderes keramisches Material ist, (3) ein Gemisch oder ein Verbundstoff der Materialien (1) und (2), ein Schnellarbeitsstahl, Eisen, Molybdän, Wolfram oder eine Legierung davon ist, die mittlere Dicke der Diamant- und/oder diamantartigen Kohlenstoffdeckschicht 0,1 bis 300 µm beträgt und die Zwischenschicht eine Gesamt-Durchschnittsschichtdicke von 0,2 bis 300 µm aufweist.

2. Beschichteter Hartstoff nach Anspruch 1, worin die Zwischenschicht eine Fläche von mindestens 10 %, bezogen auf die gesamte, mit Diamant- und/oder diamantartigem Kohlenstoff zu beschichtende Oberfläche, bedeckt.

3. Beschichteter Hartstoff nach Anspruch 1 oder Anspruch 2, worin die Zwischenschicht eine äußerste Oberfläche aufweist, die aus mindestens einem von Siliziumnitrid, einem Siliziumnitrid enthaltendem Material, Sialon oder einem Sialon enthaltenden Material besteht.

4. Beschichteter Hartstoff nach Anspruch 1 oder Anspruch 2, worin die Zwischenschicht eine äußerste Oberfläche aus Siliziumcarbid oder einem Siliziumcarbid enthaltenden Material aufweist.

5. Beschichteter Hartstoff nach Anspruch 1 oder Anspruch 2, worin die Zwischenschicht eine äußerste Oberfläche aus Aluminiumoxid oder einem Aluminiumoxid enthaltenden Material aufweist.

6. Beschichteter Hartstoff nach Anspruch 1 oder Anspruch 2, worin die Zwischenschicht eine äußerte Oberfläche aufweist, die aus (1) mindestens einem Übergangsmetall der Gruppe 4, 5, 6 und 7 des Periodensystems, Legierungen dieser Metalle und (2) Carbiden, Nitriden und/oder Carbonitriden davon besteht.

7. Beschichteter Hartstoff nach Anspruch 1 oder Anspruch 2, worin die Zwischenschicht eine äußerste Oberfläche aufweist, die aus (1) Titan, (2) Titancarbid oder -carbonitrid, (3) Carbiden oder Carbonitriden von Titan und mindestens einem anderen Metall und/oder (4) Materialien, die die Materialien (1) bis (3) enthalten, besteht.

8. Beschichteter Hartstoff nach Anspruch 1 oder Anspruch 2, worin die Zwischenschicht eine äußerste Oberfläche aufweist, die aus (1) Wolfram, (2) Wolframcarbid oder - carbonitrid, (3) Carbiden oder Carbonitriden von Wolfram und mindestens einem anderen Material und/oder (4) Materialien, die die Materialien (1) bis (3) enthalten, besteht.

9. Beschichteter Hartstoff nach Anspruch 1 oder Anspruch 2, worin ein Material in hexagonaler Säulenform mit einem Seitenverhältnis von mindestens 1,5 in der äußersten Oberfläche der Zwischenschicht vorhanden ist.

10. Beschichteter Hartstoff nach Anspruch 1 oder Anspruch 2, worin ein Material in Nadel-Form in der äußersten Oberfläche der Zwischenschicht vorhanden ist.

11. Beschichteter Hartstoff nach einem der vorhergehenden Ansprüche, worin die Zwischenschicht eine Mehrfachschicht ist.

## Revendications

1. Matériau dur revêtu comprenant une couche de revêtement en diamant et/ou en carbone de structure similaire à celle du diamant formée sur la surface du matériau dur, c'est-à-dire le substrat, et la présence d'au moins une couche intermédiaire entre la surface du substrat et la couche de revêtement en diamant et/ou en carbone de structure similaire à celle du diamant, caractérisé en ce qu'une rugosité microscopique est présente dans l'interface entre la surface la plus extérieure de la couche intermédiaire et la couche de revêtement en diamant et/ou en carbone de structure similaire à celle du diamant, ladite rugosité de surface étant représentée dans une longueur standard par un Rmax compris entre 1,0 et 30 µm lorsque la longueur standard est 50 µm, et en ce que le matériau dur est (1) un carbure cémenté, (2) Al₂O₃, un nitrure de silicium, un carbure de silicium ou une autre céramique, (3) un matériau mélangé ou composite composé des matériaux (1) et (2), un acier rapide, du fer, du molybdène, du tungstène ou un alliage de ceux-ci, et dans lequel l'épaisseur moyenne de la couche de revêtement en diamant et/ou en carbone de structure similaire à celle du diamant est de 0,1 à 300 µm, et dans lequel la couche intermédiaire présente une épaisseur de couche moyenne totale de 0,2 à 300 µm.

2. Matériau dur revêtu selon la revendication 1, dans lequel la couche intermédiaire recouvre une zone d'au moins 10 % basée sur la surface totale à revêtir par du diamant et/ou du carbone de structure similaire à celle du diamant.

3. Matériau dur revêtu selon la revendication 1 ou la revendication 2, dans lequel la surface la plus extérieure de la couche intermédiaire est constituée d'au moins un nitrure de silicium, un matériau contenant un nitrure de silicium, du sialon ou un matériau contenant du sialon.

4. Matériau dur revêtu selon la revendication 1 ou la revendication 2, dans lequel la surface la plus extérieure de la couche intermédiaire est constituée de carbure de silicium ou un matériau contenant du carbure de silicium.

5. Matériau dur revêtu selon la revendication 1 ou la revendication 2, dans lequel la surface la plus extérieure de la couche intermédiaire est constituée d'oxyde d'aluminium ou d'un matériau contenant de l'oxyde d'aluminium.

6. Matériau dur revêtu selon la revendication 1 ou 2, dans lequel la surface la plus extérieure de la couche intermédiaire est constituée (1) d'au moins un métal de transition des groupes 4, 5, 6 et 7 du Tableau Périodique, d'alliages de ces métaux et (2) de carbures, nitrures et/ou carbonitrures de ceux-ci.

7. Matériau dur revêtu selon la revendication 1 ou la revendication 2, dans lequel la surface la plus extérieure de la couche intermédiaire est constituée (1) de titane, (2) d'un carbure ou d'un carbonitrure de titane, (3) de carbures ou de carbonitrures de titane et d'au moins un autre métal et/ou (4) de matériaux contenant les matériaux (1) à (3).

8. Matériau dur revêtu selon la revendication 1 ou 2, dans lequel la surface la plus extérieure de la couche intermédiaire est constituée (1) de tungstène, (2) d'un carbure ou d'un carbonitrure de tungstène, (3) de carbures ou de carbonitrures de tungstène et d'au moins un autre matériau et/ou (4) de matériaux contenant les matériaux (1) à (3).

9. Matériau dur revêtu selon la revendication 1 ou la revendication 2, dans lequel un matériau en forme de colonne hexagonale avec un rapport d'allongement d'au moins 1,5 est présent dans la surface la plus extérieure de la couche intermédiaire.

10. Matériau dur revêtu selon la revendication 1 ou la revendication 2, dans lequel un matériau aciculaire est présent dans la surface la plus extérieure de la couche intermédiaire.

11. Matériau dur revêtu selon l'une quelconque des revendications précédentes, dans lequel la couche intermédiaire est une multicouche.
